(19) Europäisches Patentamt

European Patent Office

Office européen des brevets

(11) **EP 1 710 597 A1**

(12) **EUROPÄISCHE PATENTANMELDUNG**

(43) Veröffentlichungstag:
**11.10.2006 Patentblatt 2006/41**

(51) Int Cl.:
***G01R 33/46*** *(2006.01)*

(21) Anmeldenummer: **05007767.6**

(22) Anmeldetag: **08.04.2005**

| | |
|---|---|
| (84) Benannte Vertragsstaaten:<br>**AT BE BG CH CY CZ DE DK EE ES FI FR GB GR**<br>**HU IE IS IT LI LT LU MC NL PL PT RO SE SI SK TR**<br>Benannte Erstreckungsstaaten:<br>**AL BA HR LV MK YU** | (71) Anmelder: **Sanofi-Aventis Deutschland GmbH**<br>**65929 Frankfurt am Main (DE)**<br><br>(72) Erfinder: **Sakhaii, Peyman**<br>**65931 Frankfurt (DE)** |

(54) **Verfahren zur Datenaufnahme multidimensionaler NMR-Spektren durch frequenzabhängige Faltung**

(57)     Verfahren zur Datenaufnahme von multidimensionalen NMR-Spektren, wobei in einem SHARC-Protocol genannten Verfahren (SHaped ARrayed data acquisition Protocol) durch selektive Pulse und frequenz-abhängige Faltung Kreuzsignale beliebig im Frequenzraum verlagert werden.

EP 1 710 597 A1

Printed by Jouve, 75001 PARIS (FR)

**Beschreibung**

Ein Problem in der Aufklärung der Struktur organischer oder anorganischer Verbindungen ist, dass multidimensionale NMR-Spektren in der Regel recht komplex sind, wobei größere Moleküle umso komplexere multidimensionale NMR-Spektren zeigen. Die Datenaufnahme (Acquisition) von Spektren mit akzeptabler Auflösung und die Interpretation solcher Spektren ist daher mit hohem Aufwand verbunden.

Standard-NMR-Verfahren sind beispielsweise das HSQC (Heteronuclear Single Quantum Coherence) oder das HMBC (Heteronuclear Multiple Bond Correlation), siehe IUPAC-Empfehlungen für NMR-Pulssequenzen (Angew. Chem. 2003, 115, 3293 - 3301). Reynolds und Enriquez beschreiben in J. Nat. Prod. 2002, 65, 221-244 NMR-Methoden zur Strukturaufklärung von Naturstoffen. Frydman (WO 2004/011899) beschreibt eine Methode zum Aufnehmen mutidimensionaler Spektren mit einem einzelnen Scan, wobei Partitionen einer Probe in einen Satz von unabhängigen Teilen mit unterschiedlichen Resonanzfrequenzbereichen unterteilt wird, und die Probe schichtweise (volumenabhängig) mit selektiven Pulsen vermessen wird. Nachteil dieser Methode ist ihre geringe Empfindlichkeit und dass relativ große Probenmengen bzw. eine hohe Substanzkonzentration benötigt werden.

K. Takasugi beschreibt eine Methode für die spektrale Rekonstruktion von gefalteten Spektren auf der Basis von multipler Faltung, wobei während der Datenaufnahme alle Frequenzen jeweils die gleiche Faltung erfahren, was einer frequenzunabhängigen Faltung entspricht (46th ENC Conference, 10.-15. April 2005, Providence, RI, USA; Zusammenfassung online verfügbar am 6. April 2005).

Dunn und Sidebottom (Magn. Reson. Chem. 2005, 43, 124-131) beschreiben eine Methode zur Rückrechnung von gefalteten Spektren mit dem Ziel der schnelleren Auswertung der strukturellen Konfirmation von kleinen orgainschen Molekülen, wobei während der Datenaufnahme 2 oder 3 Spektren mit verschiedenen reduzierten spektralen Fenstern gemessen werden.

Ein zweidimensionales NMR-Experiment besteht aus mehreren Phasen, der ersten sogenannten Präparationsphase, einer zweiten sogenannten Evolutions- und Mischphase und der eigentlichen Detektionsphase, in der ein Interferogramm (FID) aufgezeichnet wird. Die Zeit.der Evolutionsphase, t1 genannt, ist eine variable Wartezeit, die im Bereich von Millisekunden bis Sekunden liegt, innerhalb derer sich chemische Verschiebung und Spin-Spin-Kopplungen entwickeln. Nach der Evolution- und der Mischphase Zeit t2, die ebenfalls konstant ist. Die in einem zweidimensionalen NMR-Experiment aufgezeichneten Daten werden oft im sogenannten Konturdiagramm dargestellt. Ein solches Konturdiagramm zeigt einen Schnitt entlang einer Höhenlinie durch die Kreuzsignale des Spektrums. Diese zweidimensionalen Experimente können auch als Bestandteil mehrdimensionaler Experimente durchgeführt werden.

Das Standardverfahren zur Datenaufnahme eines multidimensionalen NMR-Spektrums beruht auf der Anwendung einer bestimmten Sequenz und Abfolge von Anregungspulsen hoher Frequenz (Pulses) und Wartezeiten (Delays). Die dabei entstehenden Kohärenzordnüngen von Magnetisierungen, ihrer Transfer in andere Kohärenzen und die Regeln zur Auswahl der gewünschten Magnetisierungen wird vollständig durch den product operator Formalismus beschrieben.

Bei der konventionellen Methode zur Datenaufnahme eines multidimensionalen Spektrums, wird im Allgemeinen in der Evolutionsphase die Evolutionszeit linear inkrementiert, wobei die Inkrementierungszeit $\Delta t1$ in der Evolutionsphase das Nyquist-Theorem (Gleichung 1) erfüllt, um das korrekte spektrale Fenster in der indirekten Dimension zu liefern.

Gleichung 1:    IN0 = 1/(Nd0 x BF1 x SW1), wobei
d0 = initial delay (initiale Wartezeit),
Nd0 = Anzahl von $\triangle$t1 Inkrementen,
SW1 = Spektrales Fenster in der indirekten Dimension,
BF1 =    Basisfrequenz (z.B. bei 9.39 T für $^1$H 400.13 Hz und für $^{13}$C 100.58 Hz,
IN0 =    Inkrementierungszeit

Bei der Realisierung der oben beschriebenen experimentellen Bedingungen unter Einhaltung des Nyquist-Theorems zur korrekten Digitalisierung der Daten erhält man nach der Fouriertransformation (FT) in beiden Dimensionen (Gleichung 2) die Kreuzsignale in der Frequenzdomäne, wobei die chemische Verschiebung der gemessenen Kreuzsignale in der indirekten Dimension korrekt (i.e. nicht gefaltet) wiedergegeben sind.

Gleichung 2:    S(t1, t2) $\rightarrow$ FT $\rightarrow$ S(v1, v2), wobei
S(t1, t2) = Signal nach Inkrementierungszeit
S(v1, v2) = Fouriertransformiertes Signal

Aus der Gleichung 1 ist zu entnehmen, dass das indirekte spektrale Fenster SW1 in umgekehrter Proportion

zur Inkrementierungszeit IN0(=$\triangle$t1) steht. Das bedeutet, dass bei einer Verlängerung von $\triangle$t1 das indirekte spektrale Fenster SW1 verkleinert wird und als Konsequenz daraus alle Kreuzsignale eines multidimensionalen Spektrums, die außerhalb des gewählten spektralen Fensters liegen, nicht mehr an der ursprünglichen chemischen Verschiebung auftreten. Dieses Phänomen der Faltung in der Datenaufnahme von NMR-Spektren ist in der Literatur (Two-Dimensional NMR spectroscopy, 2nd ed. 1994, W.R. Croasmun und R.M.K. Carlson, Wiley-VCH, Seite 493-503) ausführlich beschrieben und führt dort generell zur Verkürzung der Messzeit und zur Erhöhung der digitalen Auflösung der Kreuzsignale, was sich aus den Gleichungen 3-5 ergibt:

$$\text{Gleichung 3:} \quad DR = SW\ [Hz]\ /\ TD1^*, \text{ wobei}$$
$$SW\ [Hz] = \text{Spektrales Fenster in Hertz}$$
$$DR = \text{Digitale Auflösung,}$$
$$TD1^* = \text{Complex number of experiments}$$

$$\text{Gleichung 4:} \quad DR = 1\ /\ AQ(t1)$$
$$AQ(t1) = \quad \text{Acquisitionszeit in der indirekten Dimension nach Gleichung 5.}$$

$$\text{Gleichung 5:} \quad AQ(t1) = Nd0 \times IN0 \times TD1^*.$$

Für die chemischen Verschiebungen der Kreuzsignale (apparent frequency vi) in der indirekten Dimension aller angeregten und in der Evolutionszeit befindlichen Kohärenzen und unabhängig von einer möglichen Verletzung des Nyquist-Theorems gilt laut Gleichung 6 eine direkte funktionale Abhängigkeit von der $\triangle$t1-Inkrementierungszeit.

$$\text{Gleichung 6:} \quad \nu_i(\Omega s) = f\ (\triangle t1)$$
$$\nu_{i+1}(\Omega s) = f\ (\triangle t1), \text{ wobei}$$
$$\nu_i(\Omega s),\ \nu_{i+1}\ (\Omega s) = \text{chemische Verschiebung des Kreuzpeaks } i \text{ bzw. } i+1,$$
$$f\ (\triangle t1) = \text{Funktion der Inkrementierungszeit } \triangle t1.$$

Die Analyse der Kreuzsignale (cross peaks) eines multidimensionalen NMR-Spektrums z.B. eines HSQC-Spektrums zeigt bei genauerer Betrachtung der Resonanzfrequenzen, dass sich die Kreuzsignale abhängig von Ihrer chemischen Verschiebung in vorzugsweise übereinanderliegenden Signalgruppen (Cluster) im Frequenzraum anordnen. Als Konsequenz davon, gibt es Frequenzbereiche in dem multidimensionalen Spektrum, die keine Kreuzsignale und damit keine Informationen beinhalten.

Diese Beobachtung wird erhärtet, wenn man sich vergegenwärtigt, dass beispielweise in erster Näherung die elektronenarmen aromatischen Protonen (Tieffeld-verschobene Signalbereiche) stets mit Kohlenstoffen im Tieffeldverschobenen Bereichen in einem HSQC-Spektrum Kreuzsignale ergeben. Da jedoch in der Routinemessung aus Gründen der Einhaltung des Nyquist-Theorems über den gewünschten chemischen Verschiebungsbereich gemessen wird, gibt es zwangsläufig leere Frequenzräume, die keine Signale beinhalten. Ein Standard-HSQC-Spektrum vom einem organischen Molekül mittlerer Molmasse ergibt durchschnittlich ein Spektrum, in dem mehr als 95% der Frequenzbereiche keinerlei Informationen in Form von Kreuzsignalen beinhalten. Bei kleinen Moleküle bleibt bis zu 99% des Frequenzraums ungenutzt.

In der NMR-Spektroskopie gibt es ferner verschiedene Arten von Pulsen. Sogenannte "hard pulses" sind rechteckige Pulse mit hoher Energie und weitem Anregungsfrequenzband (rectangular high power pulses with a wide frequency excitation band). Hard pulses sind unselektiv. "Shape pulses" sind Pulse, die selektiv bestimmte Frequenzbereiche anregen. Solche Pulse sind beispielsweise Gauß-, Rectangular-, Sine-, BURP-Pulse, und werden im folgenden zusammenfassend shape pulses oder selektive Pulse genannt (amplitude and power shaped pulses with a selective excitation band), siehe beispielsweise Freeman, Journal of Progress in Nuclear Magnetic Resonance Spectroscopy 1998, 32, 59-106.

Die vorliegende Erfindung stellt ein Verfahren zur Verfügung, mit der Cluster bestehend aus mehreren Kreuzsignalen selektive so beeinflusst werden, dass einzelne Cluster oder Clustergruppen optimal über den gesamten vorhandenen Frequenzraum verteilt werden. Mit dem Verfahren ist es möglich, Kreuzsignale an beliebigen Positionen im Frequenzraum zu verlagern, was erhebliche Auswirkung auf die Vereinfachung, Auflösung und Auswertbarkeit der resultierenden multidimensionalen Spektren hat.

Das erfindungsgemäße Verfahren beschreibt ein Verfahren zur Datenaufnahme in der multidimensionalen NMR-Spektroskopie. Das SHARC-Protocol genannte Verfahren (SHaped ARrayed data aCquisition Protocol) nutzt die Eigenschaften von selektiven Pulsen mit spezifischer Anregung in den gewünschten Frequenzbereichen, die in Kombination mit Faltung der Frequenzen der indirekten Dimension, Kreuzsignale beliebig im Frequenzraum zu verlagern.

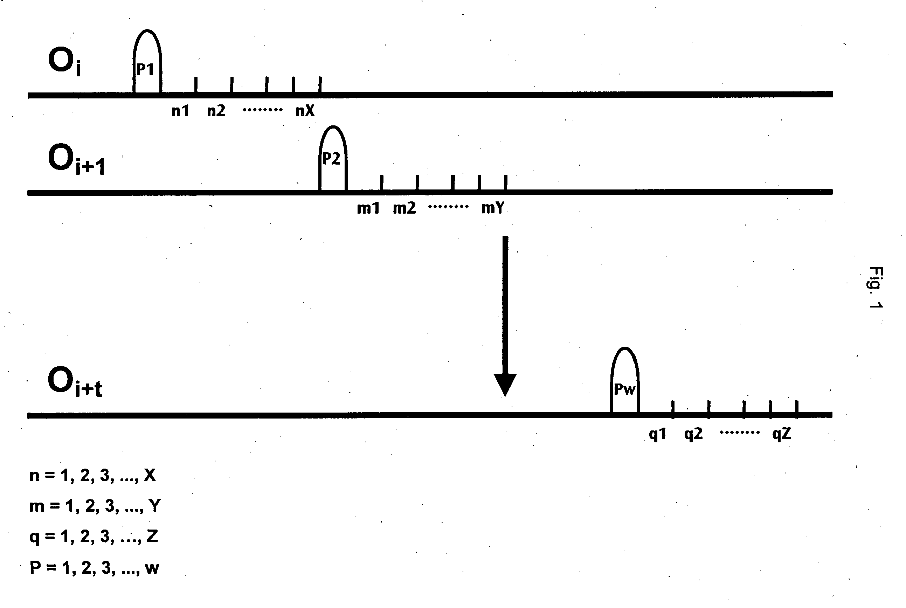

Figur 1 zeigt schematisch eine Ausführung der SHARC- Sequenz mit einer Reihe von selektiven Pulsen P1, P2, etc., die durch eine determinierte Anzahl von inkrementierbaren Wartezeiten (Delays = {n1, n2, ... nX}, {m1, m2,.... mY}, etc.) getrennt sind. Die Anzahl der inkrementierbaren Delays und die Anzahl der anzuwendenden selektiven Pulse (und somit die Frequenzbereiche $O_i$, $O_{i+1}$ etc.) kann beliebig gewählt werden.

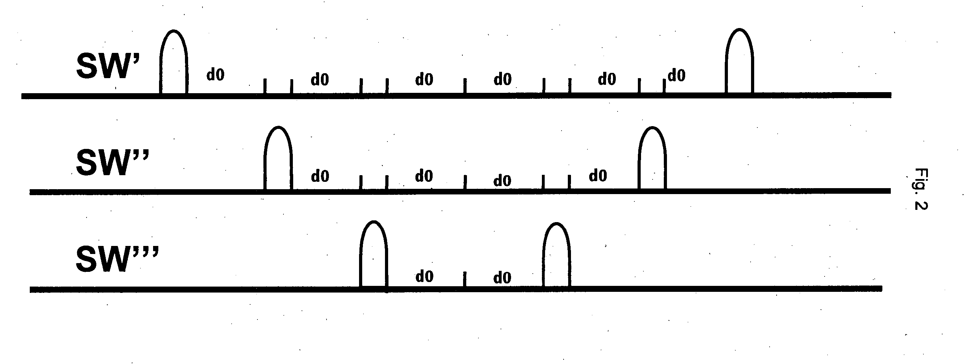

Die Inkrementierungszeit kann konstant sein - dies ist in Fig. 2 und in Fig. 1 für den Fall X=Y=...=Z dargestellt - oder variabel sein (Fig. 1, wobei die Anzahl der Inkremente veränderlich ist, X≠Y≠...≠Z).

Figur 2 zeigt die Realisierung von verschiedenen Spektralen Fenstern in der indirekten Dimension als Funktion von spezifischen Frequenzen. Dabei kommt es nach der Anregung der Frequenzen durch die jeweiligen selektiven Pulse und der Generierung der transversalen Magnetisierung zur Evolution der chemischen Verschiebung und der Spin-Spin-Kopplung:

$$[Shape\ P1] - [\Delta t1]m - [Shape\ P2] - [\Delta t1]n - \ldots\ldots - [Shape\ Pw] - [\Delta t1]q$$

Es ist leicht aus der Figur 2 zu ersehen, dass abhängig vom Zeitpunkt der Anwendung der selektiven Pulse für die jeweiligen Frequenzen SW', SW" etc. unterschiedliche Evolutionszeiten der chemischen Verschiebung entstehen. Bei geeigneter Konzipierung der Sequenz erfahren die Magnetisierungen, die am Anfang der Sequenz in der Transversalen liegen, eine andere chemische Verschiebung (oder Rotation entlang der Z-Achse) als diejenigen Frequenzbereiche, die später in der NMR-Sequenzabfolge diesen selektiven Puls erfahren, wobei am Beispiel von 3 Pulsen

$$[Shape]1 = [\Delta t0]m + [\Delta t0]n + [\Delta t0]p$$

$$[Shape]2 = [\Delta t0]n + [\Delta t0]p$$

$$[Shape]3 = [\Delta t0]p.$$

Aus den oben beschriebenen Gleichungen 1 bis 6 ist der Zusammenhang zwischen der Inkrementierungszeit $\Delta t1 = IN0$ und dem spektralen Fenster SW1 in der indirekten Dimension ersichtlich:

Gleichung 7:   SW1 ≈ f (Nd0) und damit
SW1=1/(Nd0 x BF1 x INO).

Somit kann das spektrale Fenster SW1 als eine Funktion von Nd0, der einzigen Variablen in der Gleichung 7 angenommen werden, wobei gilt $\Delta t1$= IN0 = konstant und BF1 = konstant. Im Unterschied dazu wird bei Standard-NMR-Messungen Nd0 konstant gehalten und IN0 abhängig vom spektralen Fenster variiert.

Dies bedeutet, dass abhängig von der Anzahl der Inkrementierungszeiten $\Delta t1$ alle von einem selektiven Puls getroffenen Frequenzen eine eindeutige und von anderen Frequenzen unterscheidbare spektrale Fenster SW1 besitzen.

Im Gegensatz zur normalen Faltung eines multidimensionalen NMR-Spektrums liegt hier eine frequenzabhängige Faltung des resultierenden Spektrums vor, mit der Konsequenz, dass die Kreuzsignale nicht mehr an ihrer ursprünglichen chemischen Verschiebung auftreten, sondern abhängig von ihrer Frequenz verschoben, also "gefaltet" sind.

Somit ist es unter anderem möglich zwei dicht bei einander liegende Kreuzsignale, die jedoch mindestens durch einen selektiver Puls getrennt angeregt werden können, unterschiedlich zu falten und damit ihr Erscheinen in einem multidimensionalen Spektrum zu verändern. Dies hat erhebliche Bedeutung für die Auflösung des Spektrums und die Signalentzerrung.

Das erfindungsgemäße Verfahren bietet darüber hinaus die folgenden Variationsmöglichkeiten der Parametrisierung, um die Lage der Kreuzsignale beliebig zu verändern:

1. Die Anzahl und der Typ (beispielsweise Gauß, Rectangular, Sine, BURP) der angewendeten selektiven Pulse kann innerhalb einer Sequenz frei gewählt werden.

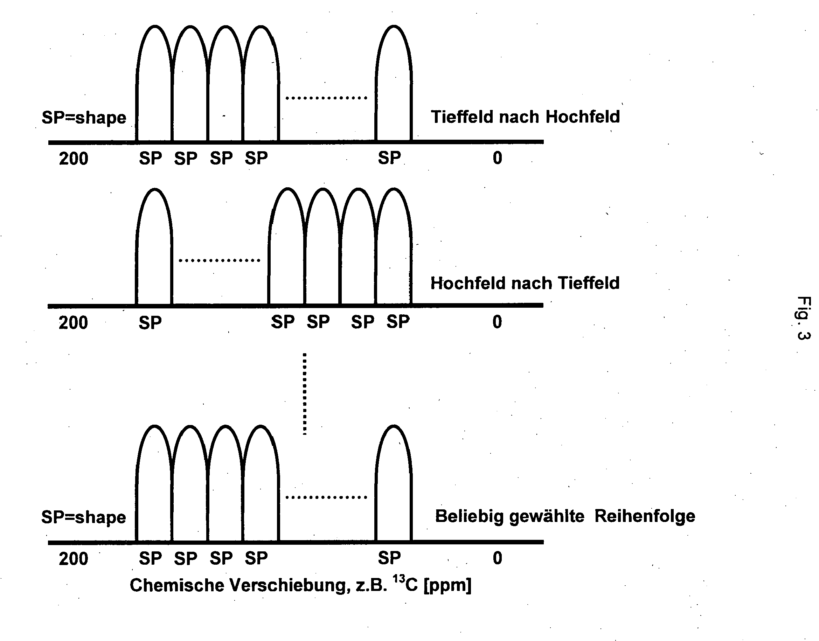

2. Bei der Anregung über die gewählten Frequenzbereiche kann die Reihenfolge der angewendeten phasenmodulierten selektiven Pulse frei gewählt werden, um eine optimale Entzerrung der resultierenden Spektren zu erreichen, siehe Fig. 3.

3. Die Anzahl der Inkrementszeiten $\triangle t1$ (Delays) innerhalb der angewendeten selektiven Pulse ist frei wählbar, wobei der Grad der Faltung der Kreuzsignale durch die Größe von $\triangle t1$ gesteuert wird.

4. Die Dauer der Inkrementierungszeiten $\triangle t1$ ist frei wählbar, siehe Fig. 1 n, m, ..., q frei wählbar.

Bei der Anwendung des SHARC Protokolls werden die durch die selektiven Pulse ausgewählten Frequenzen beliebig gewählte spektrale Fenster in der indirekten Dimension zugeordnet (siehe Fig. 3).

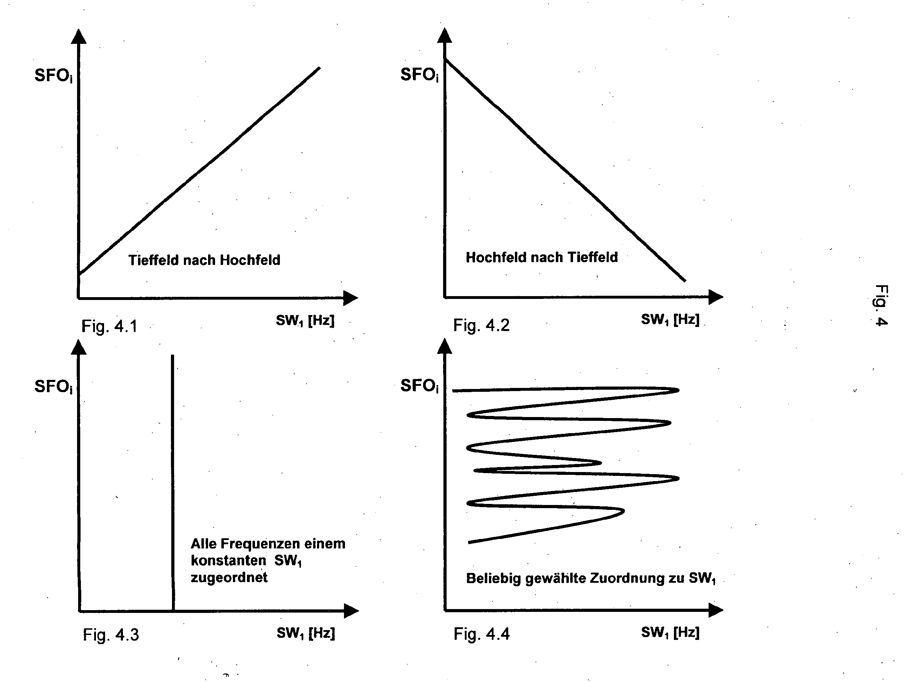

Figur 4.3 zeigt ein Experiment mit "normaler" Faltung: Allen in der t1-Evolutionszeit befindlichen Frequenzen (z.B. $^{13}$C-Verschiebungsachse) wird das gleiche spektrale Fenster SW1 zugeordnet.

Das Prinzip des erfindungsgemäßen Verfahrens wird in Fi. 4.1, 4.2 und 4.4 dargestellt: Unterschiedliche spektrale Fenster SW1 werden in der indirekten Dimension beliebig ausgewählten in der Evolutionszeit befindlichen transversalen Magnetisierungen zugeordnet. Die Reihenfolge der Zuordnung von SW1 zu den einzelnen gewählten Frequenzen (transversale Magnetisierungen in der t1-Dimension) kann von Tieffeld nach Hochfeld (Fig. 4.1 ), von Hochfeld nach Tieffeld (Fig. 4.2) oder in beliebig gewählter Reihenfolge (Fig. 4.4) erfolgen. Bevorzugt ist ein Verfahren, bei dem die Zuordnung beliebig gewählt wird, um eine maximale Signalseparation zu erreichen.

Für die Aufnahme der Daten eines normalen multidimensionalen NMR-Experirnents definiert Gleichung 6 die Lage der Kreuzsignale als Funktion der Inkrementierungszeit $\triangle t1$.

Unter Beachtung des SHARC Protokolls muss im Unterschied zu Gleichung 6 folgender Ausdruck für die Beschreibung der Lage der Kreuzsignale angenommen werden:

$$\text{Gleichung 8} \quad \nu_i(\Omega s) = f(N \times \triangle t1)$$
$$\nu_{i+1}(\Omega s) = \quad f(M \times \triangle t1)$$

Aufgrund der Komplexität der Spektren zahlreicher organischer Verbindungen kann durch das SHARC Protokoll ein erheblicher Beitrag zur systematischen Vereinfachung der Datenaufnahme und der Interpretation geleistet werden. Denn ein komplexes Spektrum wird in zahlreiche kleinere durch selektive Pulse ausgewählte Bereiche und Spektren überführt und diese dann ausgewertet (automatische Auswertungssysteme). Durch die Variation der oben beschriebenen spektralen Parameter wird es möglich sein, multidimensionale Spektren der bestimmten Regionen eines komplexen Spektrums aufzunehmen, wobei gleichzeitig die Lage der Signale der Teilspektren iterativ optimiert werden kann, so dass möglichst der gesamte zur Verfügung stehende Frequenzraum ausgenutzt wird und dadurch keine hohe digitale Auflösung benötigt wird.

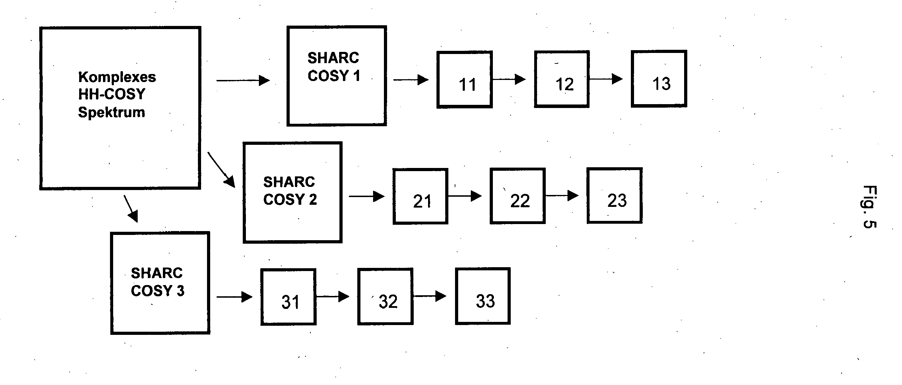

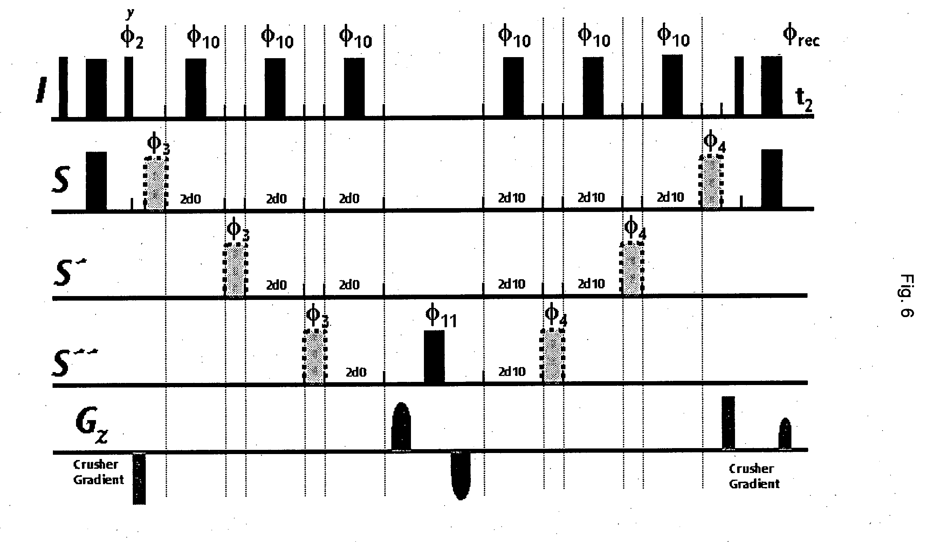

Figur 5 zeigt eine solche Systematisierung der Datenaufnahme. Das SHARC-Protokoll kann beispielsweise im Bereich der automatischen Strukturbestimmung eingesetzt werden, da insgesamt eine Vereinfachung eines komplexen multidimensionalen Spektrums in Teilspektren vorgenommen werden kann.

Das SHARC-Protokoll kann in beliebigen homo- und heteronuklearen multidimensionalen NMR-Experimenten (n größer oder gleich 2) wie HSQC, HMBC, COSY, TOCSY, HSQC-TOCSY usw. implementiert werden. Homo- und heteronuklearen n-dimensionalen NMR-Experimente sind literaturbekannt (beispielsweise in Angew. Chem. 2003, 115, 3293-3301 aufgelistet). Bevorzugt sind 2- und 3-dimensionale NMR-Experimente. Bevorzugt sind ferner Kreuzsignale von einem der folgenden Kerne mit einem gleichen oder verschiedenen Kern: $^1$H, $^{13}$C, $^{15}$N, $^{31}$P.

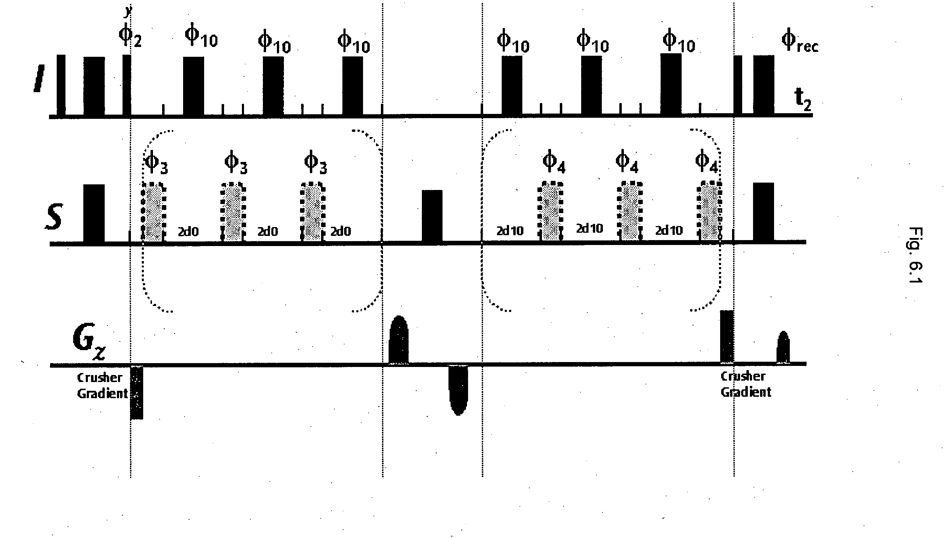

Eine Version der Implementierung des obenvorgestellten SHARC-Konzepts in ein HSQC-Experiment ist Fig. 6 bzw. 6.1 wiedergegeben. Das Experiment wird demnach als SHARC-HSQC bezeichnet. Fig. 6 zeigt eine SHARC-HSQC-Sequenz, wobei zur Vereinfachung nur 3 selektive Pulse S, S' und S'' wiedergegeben sind.

Fig. 6.1 zeigt die gleiche Sequenz, wobei die selektiven Pulse übereinander dargestellt sind.

Es handelt sich um eine Gradienten-unterstützte Phasen-empfindliche Version von SHARC-HSQC: Die abgebildete SHARC-HSQC Sequenz kann als eine Summe aus N verschiedenen selektiven HSQC's mit jeweils unterschiedlichen spektralen Fenstern in t1 verstanden werden. In den Abbildungen wurden aus Gründen der Übersichtlichkeit nur drei selektive Pulse (und somit drei verschiedene Phasen modulierte selektive Pulse mit den Phasen $\phi3$, $\phi4$ etc.) eingezeichnet. Es gibt jedoch keine Einschränkung hinsichtlich der Anzahl der einzusetzenden selektiven Pulse. Die Phasenzyklen sind wie folgt angegeben: $\phi3=0\ 2$; $\phi4=0\ 0\ 2\ 2$; $\phi11=0\ 0\ 0\ 0\ 2\ 2\ 2\ 2$; $\phi rec=0\ 2\ 2\ 0$ (receiver phase), Frequenzdiskriminierung in t1 ist durch das Echo/Antiecho-Protokoll. Es werden nur die $\triangle t0$ delays durch die entsprechenden $\triangle t1$ -Zeiten inkrementiert. In Fig. 6 bzw. 6.1 wurden die d0's inkrementiert, die d10 blieben konstant.

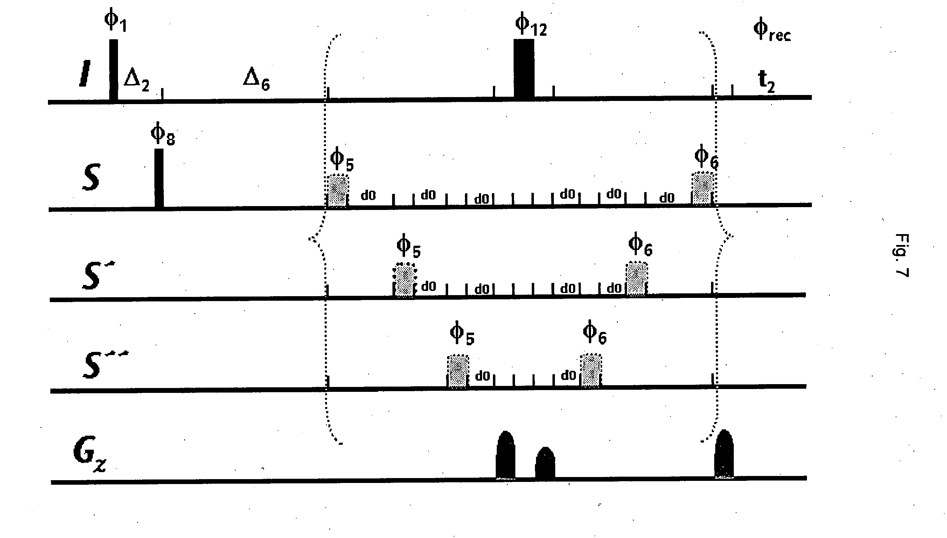

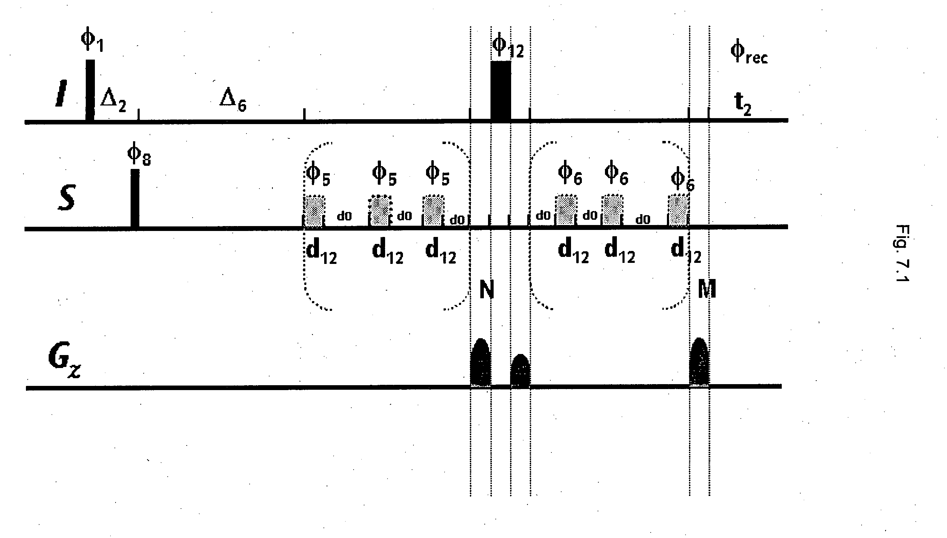

Eine Version der Implementierung des SHARC Konzeptes in das HMBC-Experiment ist in Fig. 7 und Fig. 7.1 wiedergegeben. Das Experiment kann demnach als SHARC-HMBC bezeichnet werden. Es handelt sich um eine Gradienten-unterstützte Phasen-unempfindliche (magnitude mode) Version von SHARC-HMBC: Die abgebildeten SHARC-HMBC Sequenzen können als eine Summe aus N verschiedenen selektiven HMBC's mit jeweils unterschiedlichen spektralen Fenster in $\omega 1$ verstanden werden. Hier wurde aus Gründen der Übersichtlichkeit drei selektive Pulse (und somit drei verschiedene Phasen modulierte selektive Pulse mit der Phase $\phi 3$) eingezeichnet. Es gibt jedoch keine Einschränkung hinsichtlich der Anzahl der einzusetzenden selektiven Pulse. Die Phasenzyklen sind wir folgt angegeben: $\phi 5=0\ 2$; $\phi 6=0\ 0\ 2\ 2$; $\phi 12=0\ 0\ 0\ 0\ 2\ 2\ 2\ 2$; $\phi rec=0\ 2\ 2\ 0$; Frequenzdiskriminierung in $\omega 1$ ist durch Phasenmodulation realisiert (phase twisted line shape); $\Delta 2=1/2*^1J_{HC}$, $\Delta_6=1/2*^nJ_{HC}$ = defocusing delay.

Die in Fig. 6 bis 7.1 eingezeichneten Pulse haben die folgende Bedeutung:

ausgefülltes Rechteck schmal (I) = entspricht 90 Grad hard pulse;

ausgefülltes Rechteck breit (I) = entspricht 180 Grad hard pulse;

hellgraues Rechteck mit gestricheltem Rand (S, S', S'') = entsprechen selektiven 90 Grad Pulsen;

dunkelgraues Rechteck ($G_z$) = crusher Gradient (Z-Achse) zur Eliminierung von, ungewünschten transversalen Magnetisierungen;

dunkelgraue Halbkegel ($G_z$) = Gradienten zur Auswahl der gewünschten Magnetisierungen sogenannter Selektionsgradienten.

Das hier vorgestellte Verfahren ermöglicht daher eine vereinfachte Auswertbarkeit von multidimensionalen NMR-Spektren und eine sehr schnelle Datenaufnahme von NMR-Messungen (ultra fast measurement) insbesondere bei gleichzeitig verbesserter Auflösung. Das Verfahren ist anwendbar in der Strukturaufklärung von organischen Verbindungen, beispielsweise Naturstoffen oder Peptiden. Das erfindungsgemäße Verfahren kann ferner verwendet werden in der automatischen Strukturbestimmung, der Bio-NMR-Spektroskopie, zum Screening organischer Verbindungen, bei der Analyse komplexer Mineralölfraktionen und in Metabonomics (complex mixtures).

Das erfindungsgemäße Verfahren zur Datenaufnahme multidimensionaler Spektren ist daher dadurch gekennzeichnet, dass

(1.) ein multidimensionales Standard-Spektrum aufgenommen wird,
(2.) ein Frequenzbereich mit einem Bereich von Kreuzsignalen (Cluster), vorzugsweise überlappenden Kreuzsignalen ausgewählt wird,
(3.) der in Schritt (2.) ausgewählte Frequenzbereich durch selektive Pulse nacheinander so angeregt werden, dass jeweils ein gefaltetes multidimensionales Spektrum erhalten wird, und das entsprechende spektrale Fenster SW1 der indirekten Dimension zugeordnet wird,
(4.) Schritt (2.) und (3.) insgesamt x-mal wiederholt wird, bis alle gewünschten Frequenzbereiche in ihren entsprechenden spektralen Fenstern SWx in der indirekten Dimension zugeordnet sind, wobei n der Anzahl der gewählten selektiven Pulse entspricht.

Das multidimensionale Standard-Spektrum in Schritt (1.) ist ein niederaufgelöstes oder ein hochaufgelöstes Spektrum, vorzugsweise ein niederaufgelöstes Spektrum.

Vorzugsweise wird in dem erfindungsgemäßen Verfahren in Schritt (3.) eine Anregungssequenz nach Fig. 1, oder eine Pulssequenz nach Fig. 6.1 oder Fig. 7.1 verwendet.

Eine Rückrechnung der in Schritt (4.) erhaltenen SHARC-HSQC-Daten auf die chemischen Verschiebungen bzw. spektralen Fenster des dazugehörigen Standard-HSQC-Spektrums ist nach Dunn und Sidebottom (Magn. Reson. Chem. 2005, 43, 124-131) oder Takasugi (46th ENC Conference, 10.-15. April 2005, Providence, RI, USA) möglich.

In einer besonders bevorzugten Ausführung wird das SHARC-Protokoll in einem zweidimensionalen HSQC-NMR-Experiment implementiert, also ein Spektrum, das zwei Frequenzachsen aufweist. Die Intensitäten der dabei entstehenden Kreuzsignale entsprechen der dritten Dimension.

Als ein Beispiel für die Datenaufnahme im Sinne des beschriebenen SHARC Protokolls wurde ein zweidimensionales SHARC-HSQC zur Strukturaufklärung des Naturstoffs Cyclosporin A:

Die SHARC-HSQC Messungen des zyklischen Peptids Cyclosporine A (50mM) [Bruker Standard Probe] gelöst in deuteriertem Benzol $C_6D_6$ (Lock) wurden auf einem Bruker AVANCE 400 Spektrometer mit einer Spektrometerfrequenz von 400,13 MHz (9.39 Tesla) und bei einer Temperatur von 300 K gemessen. Phasen-sensitive 2D-SHARC-HSQC Messungen wurden mit der Sequenz laut Fig. 6 bzw. 6.1 durchgeführt.

Vor der Durchführung des eigentlichen Experimentes wird optional eine $\pi/2$ (90 Grad) Protonen-Pulskalibrierung durchgeführt, um später eine maximale Transfer der Magnetisierung zu gewährleisten. Ferner sollte die Leistung der $\pi/2$ selektiven Pulse im Zusammenhang mit der Pulslänge und der sogenannten Anregungsbandbreite entweder direkt an der Probe kalibriert werden oder mit der Spektrometersoftware angenähert berechnet werden. Beide Lösungen zur Kalibrierung der Leistung der $\pi/2$ selektiven Pulse können für das vorliegende Verfahren eingesetzt werden.

Um die Frequenzbereiche für die selektive Anregung in dem eigentlichen SHARC-HSQC-Experiment abzuschätzen, wurde im Vorfeld ein Standard 2D-HSQC mit niedriger digitaler Auflösung aufgenommen. Dies ist nicht unbedingt notwendig für die Durchführung des Experimentes. Es versteht sich von selbst, dass ebenfalls Informationen aus anderen NMR-Spektren e.g. 1 D-$^{13}$C-NMR, multiplizitäts-editierte $^{13}$C (DEPT) hilfsweise herangezogen werden können.

Danach können Kreuzsignalhaufen (Signalcluster) bestimmt und den Anregungsbereichen der selektiven Pulse zugeordnet werden. Zusätzlich kann dadurch abgeschätzt werden, wie viele selektive Pulse zur Durchführung des SHARC-HSQC Experimentes eingesetzt werden müssen. Es ist anzumerken, dass beim Übergang zu höheren Magnetfeldern um so mehr selektive Pulse innerhalb der Frequenzbereiche eingesetzt werden können und somit ein höherer Grad an Kreuzsignalverteilung über den vorhandenen Frequenzraum erreicht wird. Dies wird anhand der folgenden einfachen Rechnung deutlich: Bei einer Magnetfeldstärke von 9.39 Tesla besitzt das spektrale Fenster von 20 ppm im Protonenspektrum etwa 8 KHz Bandbreite, während die Bandbreite bei einem 900 MHz-Spektrometer beim gleichen spektralen Fenster etwa 18 KHz beträgt. Bei der Annahme eines selektiven Pulses mit einer Anregungsbandbreite von 400 Hz, ist leicht einzusehen, dass etwa doppelt so viele selektiver Pulse bei höherem Feld implementiert werden können.

Bei der Durchführung der unten angegebenen SHARC-HSQC Sequenz und um eine selektive Anregung der Frequenzbereiche in der indirekten Dimension zu erreichen, sind unter anderem phasenmodulierte selektive Pulse (abhängig von aktuellen Transmitter Offset) zum Einsatz gekommen. Dadurch ist es möglich, bei konstant gehaltenem Transmitter Offset die jeweiligen Frequenzregionen durch die selektiven Pulse anzuregen, um die Phasenkohärenz der Frequenz zu erhalten. Als Pulsfolge wurde die Sequenz nach Fig. 6 bzw. 6.1 verwendet.

Das SHARC-HSQC von Cyclosporine A wurde, mit 256 komplexen Datenpunkten in t1 und mit 2K Datenpunkten in t2 aufgenommen. Es wurden pro Datenpunkt jeweils 8 Transienten aufgenommen. Die spektrale Weite in t2 betrug 8250 Hz. Während der Signaldetektion in t2 wurde zwecks heteronuklearer Entkopplung eine GARP Sequenz mit einer Feldstärke von 3333 Hz angewendet. Nach Zero-Filling, Linear prediction und Fourier-Transformation wurde ein 2K X 512 Datenmatrix erhalten. Die Relaxationsdelay betrug 2 Sekunden. Zur Unterscheidung der Vorzeichen der Frequenzen in der indirekten Dimension und damit einhergehenden Phasenempfindlichkeit des 2D-SHARC-HSQC-Spektrums, wurde ein Gradient Echo/Antiecho Verfahren eingesetzt, wobei nach jedem zweiten Datenpunkt die Phase der selektiven $\pi/2$ Pulse und die Phase des Receivers um $\pi$ invertiert wurden.

Wie bereits in der Beschreibung des 2D-NMR-Spektroskopie angedeutet, wird nun nach jedem zweiten Datenpunkt die Variable $\triangle$t0 (hier in der Zeichnung d0) um $\triangle$t1 inkrementiert. Dabei erfahren die Frequenzen in der indirekten Dimension (hier Kohlenstoff), je nachdem, zu welchem Zeitpunkt sie von den einzelnen selektiven Pulsen getroffen worden sind, unterschiedliche Rotationen um den chemischen Verschiebungsvektor.

Anhand der Pulssequenz wie in Fig. 6 und 6.1 verdeutlicht wurde zwecks der heteronuklearen Entkopplung in der t1-Evolutionszeiten geeignete $\pi$-Pulse im Protonenkanal eingesetzt. Die $\pi$-Pulse sind symmetrisch innerhalb von $\triangle$t0 bzw. n x $\triangle$t0 und nach jedem selektiven Puls im Kohlenstoffkanal eingesetzt.

Während der t1-Evolutionszeit kommt es aufgrund der Anwendung der jeweiligen selektiven Pulse, die mehrere Millisekunden lang sein können, zur Akkumulation von sogenannter phase errors, die kompensiert werden müssen. Daher re-fokussiert in der Mitte der t1-Evolutionszeiten ein sogenannter $\pi$-Hard Puls im Kohlenstoffkanal aller vorangegangenen chemischen Verschiebungen in der Weise, dass zu Beginn der Inkrementierung mit Δt1 keine Phasenfehler mehr vorliegen und somit nach der Aufnahme aller Datenpunkte und der Prozessierung der NMR-Daten keine nachträgliche Phasenkorrektur in der indirekten Dimension vorgenommen werden muss.

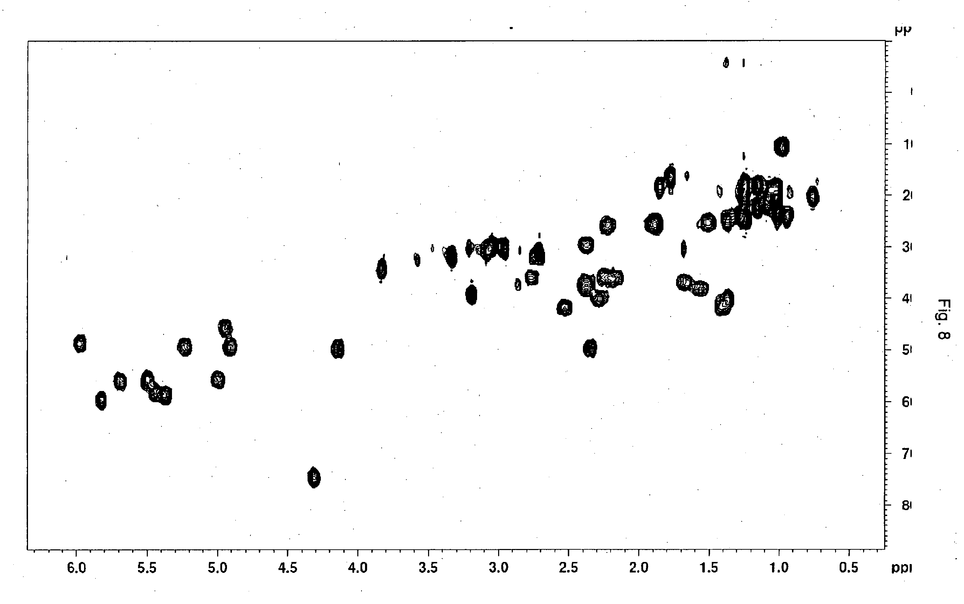

Fig. 8 zeigt ein Standard-HSQC von Cyclosporine A (Bruker standard sample).

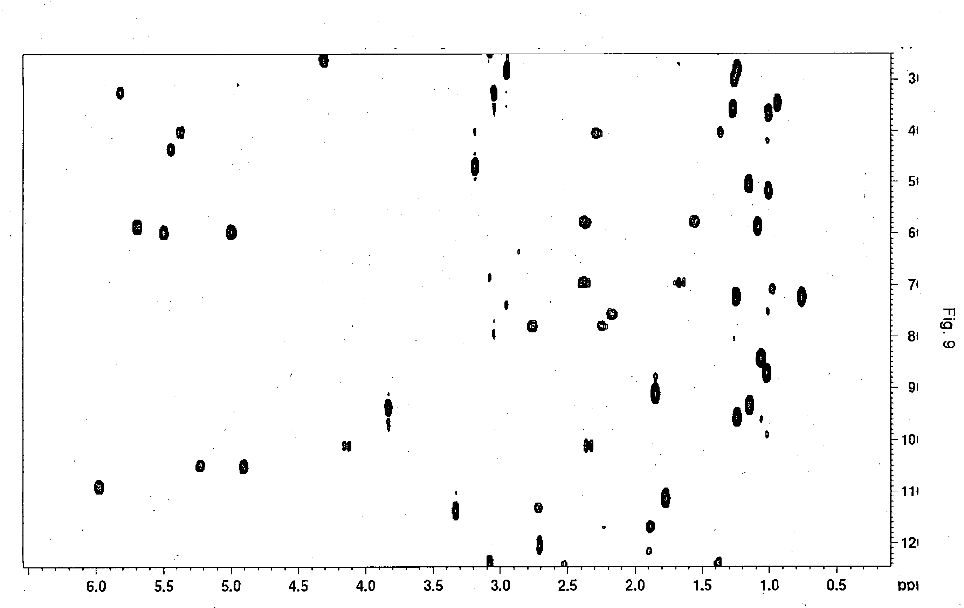

Fig. 9 zeigt ein SHARC-HSQC, das mit den oben genannten Bedingungen aufgenommen wurde. Deutlich zu erkennen sind die in bisher nicht genutzte Bereiche verlagerte cross peaks.

Folgende Parameter wurden bei der Messung des SHARC-HSQC-NMR von Cyclosporine A eingehalten (Bruker AVANCE 400 Spektrometer Auflistung):

| | |
|---|---|
| PROBHD | 5 mm BBO BB-1 H |
| PULPROG | sapefreqEXC_10 |
| TD | 2048 |
| SOLVENT | DMSO |
| NS | 8 |
| DS | 8 |
| SWH | 8250.825 Hz |
| FIDRES | 4.028723 Hz |
| AQ | 0.1242194 sec |
| RG | 12288 |
| DW | 60.600 usec |
| DE | 6.00 usec |
| TE | 300.0 K |
| d0 | 0.00000300 sec |
| d6 | 0.00000070 sec |
| d10 | 0.00000300 sec |
| d11 | 0.05000000 sec |
| IN0 | 0.00005521 sec |
| I3 | 128 |
| P3 | 9.50 usec |

```
======== CHANNEL f1 ========
```

| | |
|---|---|
| NUC1 | 1 H |
| P1 | 8.80 usec |
| p2 | 17.60 usec |
| P29 | 2000000.00 usec |
| PL1 | -1.50 dB |
| PL29 | 120.00 dB |
| SFO1 | 400.1316005 MHz |

```
======== CHANNEL f2 ========
```

| | |
|---|---|
| CPDPRG2 | garp |
| NUC2 | 13C |
| p4 | 19.00 usec |
| P11 | 2000.00 usec |
| PCPD2 | 75.00 usec |
| PL0 | 120.00 dB |
| PL2 | 2.00 dB |
| PL12 | 19.95 dB |
| SFO2 | 100.6202720 MHz |
| SP10 | 40.75 dB |

```
======== CHANNEL f2 ========
SP11                40.75 dB
SP12                40.75 dB
SP13                40.75 dB
SPNAM10              test.2
SPNAM11              test.2
SPNAM12              test.2
SPNAM13              test.2
SPOFF10             -5643.00 Hz
SPOFF11             -3905.00 Hz
SPOFF12             -2144.00 Hz
SPOFF13              0.00 Hz


====== GRADIENT CHANNEL =----
GPNAM16             SINE.100
GPNAM17             SINE.100
GPNAM18             SINE.100
GPNAM19             SINE.100
GPNAM20             SINE.50
GPX16                0.00 %
GPX17                0.00 %
GPX18                0.00 %
GPX19                0.00 %
GPX20                0.00 %
GPY16                0.00 %
GPY17                0.00 %
GPY18                0.00 %
GPY19                0.00 %
GPY20                0.00 %
GPZ16               45.00 %
GPZ17               33.00 %
GPZ18               40.00 %
GPZ19 -             38.00 %
GPZ20               40.60 %


F1 -           Acquisition parameters:
NDO                 2
TD                  256
SFO1                100.6203 MHz
FIDRES              35.374687 Hz
SW                  90.001 ppm
FnMODE              undefined


    F2 - Processing parameters:
SI                  992
SF                  400.1300000 MHz
WDW                 QSINE
```

(fortgesetzt)

F2 - Processing parameters:

| | |
|---|---|
| SSB | 2 |
| LB | 0.00 Hz |
| GB | 0 |
| PC | 1.00 |

F1 - Processing parameters:

| | |
|---|---|
| SI | 512 |
| MC2 | echo-antiecho |
| SF | 100.6127690 MHz |
| WDW | QSINE |
| SSB | 2 |
| LB | 0.00 Hz |
| GB | 0 |

**Patentansprüche**

1. Verfahren zur Datenaufnahme multidimensionaler Spektren, **dadurch gekennzeichnet, dass**

   (1.) ein multidimensionales Standard-Spektrum aufgenommen wird,
   (2.) ein Frequenzbereich mit einem Cluster ausgewählt wird,
   (3.) der in Schritt (2.) ausgewählte Frequenzbereich durch selektive Pulse nacheinander so angeregt werden, dass jeweils ein gefaltetes multidimensionales Spektrum erhalten wird, und das entsprechende spektrale Fenster SW1 der indirekten Dimension zugeordnet wird,
   (4.) Schritt (2.) und (3.) insgesamt x-mal wiederholt wird, bis alle gewünschten Frequenzbereiche in ihren entsprechenden spektralen Fenstern SWx in der indirekten Dimension zugeordnet sind, wobei n der Anzahl der gewählten selektiven Pulse entspricht.

2. Verfahren nach Anspruch 1, wobei das multidimensionale Spektrum ein 2- oder 3-dimensionales NMR-Spektrum ist.

3. Verfahren nach einem der Ansprüche 1 oder 2, wobei das multidimensionale Spektrum ein HSQC, HMBC, COSY, TOCSY oder HSQC-TOCSY ist.

4. Verfahren nach einem der Ansprüche 1 bis 3, wobei das multidimensionale Standard-Spektrum in Schritt (1.) ein niederaufgelöstes Spektrum ist.

5. Verfahren nach einem der Ansprüche 1 bis 4, wobei in Schritt (3.) eine Anregungssequenz nach Fig. 1 verwendet wird.

6. Verfahren nach einem der Ansprüche 1 bis 4, wobei in Schritt (3.) eine Pulssequenz nach Fig. 6.1 verwendet wird.

7. Verfahren nach einem der Ansprüche 1 bis 4, wobei in Schritt (3.) eine Pulssequenz nach Fig. 7.1 verwendet wird.

8. Verfahren nach einem der Ansprüche 1 bis 7, wobei die in Schritt (4.) erhaltenen chemischen Verschiebungen in die chemischen Verschiebungen des multidimensionalen Standard-Spektrums zurückgerechnet werden.

9. Verwendung eines Verfahrens nach einem der Ansprüche 1 bis 8 zur Vereinfachung der Auswertung von multidimensionalen Spektrum.

10. Verwendung nach Anspruch 9 zur Strukturaufklärung von organischen Verbindungen, in der automatischen Strukturbestimmung, der Bio-NMR-Spektroskopie, zum Screening organischer Verbindungen, bei der Analyse komplexer Mineralölfraktionen und in Metabonomics.

$O_i$

P1

n1   n2   ········   nX

$O_{i+1}$

P2

m1   m2   ·········   mY

$O_{i+t}$

Pw

q1   q2   ········   qZ

n = 1, 2, 3, ..., X

m = 1, 2, 3, ..., Y

q = 1, 2, 3, ..., Z

P = 1, 2, 3, ..., w

Fig. 1

Fig. 2

Fig. 3

Fig. 4

SW₁ [Hz]

SFOᵢ

Hochfeld nach Tieffeld

Fig. 4.2

SW₁ [Hz]

SFOᵢ

Beliebig gewählte Zuordnung zu SW₁

Fig. 4.4

SW₁ [Hz]

SFOᵢ

Tieffeld nach Hochfeld

Fig. 4.1

SW₁ [Hz]

SFOᵢ

Alle Frequenzen einem konstanten SW₁ zugeordnet

Fig. 4.3

Fig. 5

Fig. 6

Fig. 6.1

Fig. 7

EP 1 710 597 A1

Fig. 7.1

EP 1 710 597 A1

Fig. 8

Fig. 9

EP 1 710 597 A1

**Europäisches**
**Patentamt**

**EUROPÄISCHER RECHERCHENBERICHT**

Nummer der Anmeldung

EP 05 00 7767

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | R.R. ERNST, G. BODENHAUSEN, A. WOKAUN: "Principles of NMR in One and Two Dimensions" 1992, CLARENDON PRESS , OXFORD , XP002361332 * siehe Seite 337, 2. Absatz * ----- | 1-4,8-10 | G01R33/46 |
| X | WO 2004/007016 A (THE RESEARCH FOUNDATION OF STATE UNIVERSITY OF NEWYORK) 22. Januar 2004 (2004-01-22) * Absatz [0009] - Absatz [0014] * * Absatz [0019] - Absatz [0020] * * Absatz [0053] - Absatz [0059]; Abbildungen 2,3,6-15 * ----- | 1-4,8-10 | |
| X | WO 2004/011909 A (THE RESEARCH FOUNDATION OF STATE UNIVERSITY OF NEWYORK) 5. Februar 2004 (2004-02-05) * das ganze Dokument * ----- | 1-4,8-10 | |
| | | | **RECHERCHIERTE SACHGEBIETE (IPC)** G01R |

Der vorliegende Recherchenbericht wurde für alle Patentansprüche erstellt

| Recherchenort | Abschlußdatum der Recherche | Prüfer |
|---|---|---|
| Den Haag | 5. Januar 2006 | Volmer, W |

KATEGORIE DER GENANNTEN DOKUMENTE

X : von besonderer Bedeutung allein betrachtet
Y : von besonderer Bedeutung in Verbindung mit einer
anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
nach dem Anmeldedatum veröffentlicht worden ist
D : in der Anmeldung angeführtes Dokument
L : aus anderen Gründen angeführtes Dokument

 ................................................................

& : Mitglied der gleichen Patentfamilie, übereinstimmendes
Dokument

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**                    EP 05 00 7767

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

05-01-2006

| Im Recherchenbericht angeführtes Patentdokument | Datum der Veröffentlichung | Mitglied(er) der Patentfamilie | Datum der Veröffentlichung |
|---|---|---|---|
| WO 2004007016 A | 22-01-2004 | AU 2003256479 A1<br>CA 2490305 A1<br>EP 1530732 A2 | 02-02-2004<br>22-01-2004<br>18-05-2005 |
| WO 2004011909 A | 05-02-2004 | AU 2003261277 A1 | 16-02-2004 |

Für nähere Einzelheiten zu diesem Anhang : siehe Amtsblatt des Europäischen Patentamts, Nr.12/82

EPO FORM P0461

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2004011899 A

**In der Beschreibung aufgeführte Nicht-Patentliteratur**

- *Angew. Chem.,* 2003, vol. 115, 3293-3301
- **REYNOLDS ; ENRIQUEZ.** *J. Nat. Prod.,* 2002, vol. 65, 221-244
- *46th ENC Conference,* 10. April 2005
- *Zusammenfassung online verfügbar am,* 06. April 2005
- **DUNN ; SIDEBOTTOM.** *Magn. Reson. Chem.,* 2005, vol. 43, 124-131
- **W.R. CROASMUN ; R.M.K. CARLSON.** Two-Dimensional NMR spectroscopy. Wiley-VCH, 1994, 493-503
- **FREEMAN.** *Journal of Progress in Nuclear Magnetic Resonance Spectroscopy,* 1998, vol. 32, 59-106
- *Magn. Reson. Chem.,* 2005, vol. 43, 124-131